# EUROPEAN PATENT SPECIFICATION

(11) **EP 4 236 066 B1**
(45) Date of publication and mention of the grant of the patent: **11.12.2024**
(21) Application number: 23164213.3
(22) Date of filing: 26.10.2017
(51) Int. Cl.: H03F 1/56, H03F 3/24

(54) **RADIO FREQUENCY FRONT END FOR WIRELESS COMMUNICATION**
FUNKFREQUENZ-FRONTEND FÜR DRAHTLOSE KOMMUNIKATION
FRONTAL RADIOFRÉQUENCE POUR COMMUNICATION SANS FIL

(43) Date of publication of application: 30.08.2023
(62) Divisional of application: 17794290.1
(73) Proprietor: Huawei Technologies Co., Ltd., Shenzhen, Guangdong 518129 (CN)
(72) Inventor: REGEV, Dror, 80992 Munich (DE); EZRI, Doron, 80992 Munich (DE); SHILO, Shimon, 80992 Munich (DE)
(74) Representative: Isarpatent

(56) References cited:
- US-A1- 2009 179 704
- US-A1- 2013 021 104
- US-A1- 2015 222 300
- REGEV DROR ET AL: "Modified re-configurable quadrature balanced power amplifiers for half and full duplex RF front ends", 2018 TEXAS SYMPOSIUM ON WIRELESS AND MICROWAVE CIRCUITS AND SYSTEMS (WMCS), IEEE, 5 April 2018 (2018-04-05), pages 1 - 4, XP033368672, DOI: 10.1109/WMCAS.2018.8400625

## Description

### FIELD OF THE INVENTION

The present invention relates to a radio frequency front end for wireless communication, especially to a radio frequency front end in which transmitting and receiving is performed using the same antenna.

### BACKGROUND

There are different operation modes for a radio frequency front end in which transmitting and receiving is performed using the same antenna. In a half-duplex system, only one of transmitting and receiving can be performed at a specific time. In a full-duplex system, however, both transmitting and receiving may be performed simultaneously.

In the half-duplex system, the antenna is alternatingly connected to an output port of a transmit path which is adapted to supply a transmit signal which is to be transmitted via the antenna, and to an input port of a receive path which is adapted to process a receive signal received from the antenna. In the full-duplex system, the antenna is permanently connected both to the output port of the transmit path and the input port of the receive path.

Since the input port of the receive path is adapted to receive a very small signal and generally comprises a low noise amplifier that can easily be damaged by a large signal such as the transmit signal, an isolation has to be provided between the output port of the transmit path and the input port of the receive path.

In the half-duplex system, this isolation is for example provided by a signal switch that alternatingly connects the antenna to the transmit path and the receive path, thus avoiding that the transmit signal can reach the input port of the receive path. In a full-duplex system, transmit path and receive path are for example not directly connected, but via a circulator. Circulators are usually 3 port devices that transfer a signal either clockwise or counter clockwise from port to port while isolating the signal from traveling in the reverse direction. Thus, the transmit signal can be supplied to the antenna, while it is inhibited from reaching the input port of the receive path, or at least is strongly attenuated at the input port of the receive path.

Commercial circulators are generally made of ferrite/magnetic materials and are cased in a metal housing. They are proven to have excellent power handling, offer a good isolation of about 20dB and have a low insertion loss. On the other hand, they are bulky and tall, they are not capable of being integrated with neither Monolithic Microwave Integrated Circuits nor Radio Frequency Integrated Circuits, and they are expensive.

Negar Reiskarimian, Mahmood Baraani Dastjerdi, Jin Zhou, Harish Krishnaswamy: "Highly-Linear Integrated Magnetic-Free Circulator Receiver for Full-Duplex Wireless", 2017 IEEE International Solid-State Circuits Conference, pages 316 et seq. describe a circulator-receiver in which a magnetic-free circulator is used which is based on a 3λ/4 transmission line. The insulation between transmit and receive path is therein obtained by Self Interference Cancellation (SIC) of the transmit signal. Such a circulator is capable of being integrated with Monolithic Microwave Integrated Circuits or Radio Frequency Integrated Circuits, but they have only a limited power handling capability, have a relatively high loss and Due to their wavelength dependency may only be employed in a narrow frequency band.

It is therefore desirable to provide the required insulation without the use of such elements as described above. Such an isolation stage should direct the high power transmit signal to the antenna with a minimum loss and simultaneously must be greatly reduced at the input port of the receive path. The loss from the antenna to the receive path should also be minimal. Desired attributes of a good isolation stage are, among others:
- Adequate power handling
- Good isolation
- Low insertion loss on transmit and receive paths
- Small size and low weight
- Compatibility with integration technology of power amplifiers and low noise amplifiers

### SUMMARY

It is therefore an object of the present invention to provide a radio frequency front end for wireless communication in which a sufficient isolation between the transmit path and the receive path can be provided without the need of bulky elements or without the restriction to a small bandwidth.

The foregoing and other objects are achieved by the features of the independent claims. Further implementation forms are apparent from the dependent claims, the descriptions and the figures.

According to a first aspect, a radio frequency front end for wireless communication is provided, the front end comprising an antenna port adapted to connect an antenna, a receive path comprising a receive signal input adapted to receive a receive signal, and a transmit path adapted to supply a transmit signal to the antenna port, the transmit path comprising a quadrature balanced power amplifier having a transmit signal output port connected to the antenna port and an output isolated port connected to the receive signal input.

With such a radio frequency front end, it is possible, for example, to achieve a sufficient isolation between the transmit path and the receive path in a system using the same antenna for transmitting and receiving without having to use bulky elements. In a full-duplex system wherein transmitting and receiving may be performed simultaneously, for example a circulator such as a ferrite circulator may be omitted. In a half-duplex system wherein transmitting and receiving may be performed one after the other, for example a transmit/receive switch may be simplified or entirely omitted. Further, a quadrature balanced power amplifier is easy to integrate on multiple technologies such as printed circuit boards or semiconductor chips.

In an implementation form of the first aspect, the quadrature balanced power amplifier further comprises a send signal input port adapted to receive an input signal, at least one input coupler adapted to divide the input signal into at least two coupler output signals, at least two power amplifiers, each power amplifier being adapted to amplify one of the at least two coupler output signals to obtain a respective amplified signal, and at least one output coupler connected to the send signal output port and the output isolated port of the quadrature balanced power amplifier. The at least one output coupler is adapted to combine the amplified signals so that the amplified signals constructively add to each other at the send signal output port. The at least one output coupler is adapted to combine the amplified signals so that the amplified signals cancel each other at the output isolated port.

Thereby it is possible, for example, to efficiently isolate the output isolated port from the transmit signal output port.

In a further implementation form of the first aspect, the at least one output coupler is adapted to combine the amplified signals in a way that the transmit signal formed at the transmit signal output port is an amplified input signal and/or the at least one output coupler is adapted to combine the amplified signals in a way that a signal formed at the transmit output isolated port is reduced in its amplitude with respect to the transmit signal.

Thereby it is possible, for example, to amplify an input signal on a path between the transmit signal input port and the transmit signal output port while reducing the amplitude of the signal at the output isolated port.

In a further implementation form of the first aspect, each input coupler is adapted to divide a signal into two coupler output signals having a power reduced by 3dB and a phase difference of 90° between each other.

Thereby it is possible, for example, to achieve coupler output signals which after amplification can easily be combined to add or cancel each other.

In a further implementation form of the first aspect, the quadrature balanced power amplifier comprises one input coupler, two power amplifiers and one output coupler.

Thereby it is possible, for example, to achieve a simple configuration of the quadrature balanced power amplifier.

In a further implementation form of the first aspect, the quadrature balanced power amplifier comprises more than one input coupler. An input of a first input coupler is connected to the transmit signal input port. The remaining input couplers are arranged so that an input of each of the remaining input couplers is respectively connected to a respective output of another one of the remaining input couplers to obtain a tree-structure of the input couplers.

Thereby it is possible, for example, to increase the output power available from the quadrature balanced power amplifier.

In a further implementation form of the first aspect, hybrid couplers are used for the input and/or output couplers, and/or the input and/or output couplers are integrated on a substrate or a semiconductor chip.

Thereby it is possible, for example, to further reduce the size of the radio frequency front end.

In a further implementation form of the first aspect, the power amplifiers are designed to have a high output reflection coefficient.

Thereby it is possible, for example, to reduce the input loss of the signal path between the antenna port and the receive signal input.

In a further implementation form of the first aspect, the receive path comprises an input amplifier adapted to amplify the receive signal, and a signal input of the input amplifier is connected to the output isolated port of the quadrature balanced power amplifier.

Thereby it is possible, for example, to amplify the receive signal before it is further processed.

In a further implementation form of the first aspect, the input amplifier is a low noise amplifier.

Thereby it is possible, for example, to achieve an improved signal-to-noise ratio of the amplified receive signal.

In a further implementation form of the first aspect, an input impedance of the input amplifier is matched to the characteristic impedance of the radio frequency front end.

Thereby it is possible, for example, to ensure a good operation of the quadrature balanced power amplifier with a high cancellation of the transmit signal at the output isolated port.

In a further implementation form of the first aspect, the quadrature balanced power amplifier further has an input isolated port.

Thereby it is possible, for example, to optimize the operation conditions of the quadrature balanced power amplifier.

In a further implementation form of the first aspect, a termination element having an impedance matching the characteristic impedance of the radio frequency front end is connected to the input isolated port.

Thereby it is possible, for example, to ensure a good operation of the quadrature balanced power amplifier with a high cancellation of the transmit signal at the output isolated port.

In a further implementation form of the first aspect, an antenna is connected to the antenna port.

Thereby it is possible, for example, to transmit the transmit signal and receive the receive signal via the same antenna.

The above object is also achieved in accordance with a second aspect.

According to the second aspect, a method for performing single-antenna wireless communication is provided. The method comprises transmitting a transmit signal via an antenna and receiving a receive signal via the same antenna. Receiving the receive signal comprises supplying a signal received from the antenna to a transmit signal output port of a quadrature balanced power amplifier having said transmit signal output port and an output isolated port, and supplying an output signal of said output isolated port as the receive signal to a receive signal input of a receive path adapted to process the receive signal.

With such a method it is possible, in a system using the same antenna for transmitting and receiving for example, to achieve a sufficient isolation between a transmit path and the receive path without having to use bulky elements. In a full-duplex system wherein transmitting and receiving may be performed simultaneously, for example a circulator such as a ferrite circulator may be omitted. In a half-duplex system wherein transmitting and receiving may be performed one after the other, for example a transmit/receive switch may be simplified or entirely omitted. Further, a quadrature balanced power amplifier is easy to integrate on multiple technologies such as printed circuit boards or semiconductor chips.

In an implementation form of the second aspect, transmitting the transmit signal comprises receiving an input signal at a signal input port of the balanced power amplifier, amplifying the input signal using the balanced power amplifier in order to generate a transmit signal, and supplying the transmit signal to the antenna.

With such a method it is possible, for example, to transmit an amplified signal via the antenna without affecting a receive signal which is possibly received at the same time from the same antenna (full-duplex) and or without affecting the receive path for a receive signal which is possibly received at a different time from the same antenna (half duplex).

In a further implementation form of the second aspect, the quadrature balanced power amplifier further receives an input signal at a send signal input port, at least one input coupler divides the input signal into at least two coupler output signals, at least two power amplifiers each amplify one of the at least two coupler output signals to obtain a respective amplified signal, and at least one output coupler connected to the send signal output port and the output isolated port of the quadrature balanced power amplifier combines the amplified signals so that the amplified signals constructively add to each other at the send signal output port and so that the amplified signals cancel each other at the output isolated port.

Thereby it is possible, for example, to efficiently isolate the output isolated port from the transmit signal output port.

In a further implementation form of the second aspect, the at least one output coupler combines the amplified signals in a way that the transmit signal formed at the transmit signal output port is an amplified input signal and/or the at least one output coupler combines the amplified signals in a way that a signal formed at the transmit output isolated port is reduced in its amplitude with respect to the transmit signal.

Thereby it is possible, for example, to amplify an input signal on a path between the transmit signal input port and the transmit signal output port while reducing the amplitude of the signal at the output isolated port.

In a further implementation form of the second aspect, each input coupler divides a signal into two coupler output signals having a power reduced by 3dB and a phase difference of 90° between each other.

Thereby it is possible, for example, to achieve coupler output signals which after amplification can easily be combined to add or cancel each other.

In a further implementation form of the second aspect, the quadrature balanced power amplifier comprises one input coupler, two power amplifiers and one output coupler.

Thereby it is possible, for example, to achieve a simple configuration of the quadrature balanced power amplifier.

In a further implementation form of the second aspect, the quadrature balanced power amplifier comprises more than one input coupler. An input of a first input coupler is connected to the transmit signal input port. The remaining input couplers are arranged so that an input of each of the remaining input couplers is respectively connected to a respective output of another one of the remaining input couplers to obtain a tree-structure of the input couplers.

Thereby it is possible, for example, to increase the output power available from the quadrature balanced power amplifier.

In a further implementation form of the second aspect, hybrid couplers are used for the input and/or output couplers, and/or the input and/or output couplers are integrated on a substrate or a semiconductor chip.

Thereby it is possible, for example, to further reduce the size of the radio frequency front end.

In a further implementation form of the second aspect, the power amplifiers are designed to have a high output reflection coefficient.

Thereby it is possible, for example, to reduce the input loss of the signal path between an antenna and the receive signal input.

In a further implementation form of the second aspect, an input amplifier comprised in a receive path amplifies the receive signal, and a signal input of the input amplifier is connected to the output isolated port of the quadrature balanced power amplifier.

Thereby it is possible, for example, to amplify the receive signal before it is further processed.

In a further implementation form of the second aspect, the input amplifier is a low noise amplifier.

Thereby it is possible, for example, to achieve an improved signal-to-noise ratio of the amplified receive signal.

In a further implementation form of the second aspect, an input impedance of the input amplifier is matched to the characteristic impedance of the radio frequency front end.

Thereby it is possible, for example, to ensure a good operation of the quadrature balanced power amplifier with a high cancellation of the transmit signal at the output isolated port.

In a further implementation form of the second aspect, the quadrature balanced power amplifier further has an input isolated port.

Thereby it is possible, for example, to optimize the operation conditions of the quadrature balanced power amplifier.

In a further implementation form of the second aspect, a termination element having an impedance matching the characteristic impedance of the radio frequency front end is connected to the input isolated port.

Thereby it is possible, for example, to ensure a good operation of the quadrature balanced power amplifier with a high cancellation of the transmit signal at the output isolated port.

In a further implementation form of the second aspect, an antenna is connected to the transmit signal output port.

Thereby it is possible, for example, to transmit the transmit signal and receive the receive signal via the same antenna.

The above object is also achieved in accordance with a third aspect.

According to the third aspect, a use of an output isolated port of a quadrature balanced power amplifier is provided. The quadrature balanced power amplifier has a transmit signal output port and said output isolated port. The output isolated port is used as a signal source for a receive path of a radio frequency front end for single-antenna wireless communication.

With such a use it is possible, for example, to achieve a sufficient isolation between a transmit path and the receive path without having to use bulky elements. In a full-duplex system wherein transmitting and receiving may be performed simultaneously, for example a circulator such as a ferrite circulator may be omitted. In a half-duplex system wherein transmitting and receiving may be performed one after the other, for example a transmit/receive switch may be simplified or entirely omitted. Further, a quadrature balanced power amplifier is easy to integrate on multiple technologies such as printed circuit boards or semiconductor chips.

In an implementation form of the third aspect, an antenna is connected to the transmit signal output port.

With such a use it is possible, for example, to use an output reflection of power amplifiers included in the quadrature balanced power amplifier to transmit a signal received from the antenna to the receive path.

In a further implementation form of the third aspect, an input transmit signal is supplied to a signal input port of the quadrature balanced power amplifier.

With such a use it is possible, for example, to transmit an amplified signal via the antenna without affecting a receive signal which is possibly received at the same time from the same antenna full-duplex) and or without affecting the receive path for a receive signal which is possibly received at a different time from the same antenna (half duplex.

In a further implementation form of the third aspect, the quadrature balanced power amplifier further comprises a send signal input port used to receive an input signal, at least one input coupler used to divide the input signal into at least two coupler output signals, at least two power amplifiers, each power amplifier being used to amplify one of the at least two coupler output signals to obtain a respective amplified signal, and at least one output coupler connected to the send signal output port and the output isolated port of the quadrature balanced power amplifier. The at least one output coupler is used to combine the amplified signals so that the amplified signals constructively add to each other at the send signal output port. The at least one output coupler is used to combine the amplified signals so that the amplified signals cancel each other at the output isolated port.

Thereby it is possible, for example, to efficiently isolate the output isolated port from the transmit signal output port.

In a further implementation form of the third aspect, the at least one output coupler is used to combine the amplified signals in a way that a transmit signal formed at the transmit signal output port is an amplified input signal and/or the at least one output coupler is used to com-bine the amplified signals in a way that a signal formed at the transmit output isolated port is reduced in its amplitude with respect to the transmit signal.

Thereby it is possible, for example, to amplify an input signal on a path between the transmit signal input port and the transmit signal output port while reducing the amplitude of the signal at the output isolated port.

In a further implementation form of the third aspect, each input coupler is used to divide a signal into two coupler output signals having a power reduced by 3dB and a phase difference of 90° between each other.

Thereby it is possible, for example, to achieve coupler output signals which after amplification can easily be combined to add or cancel each other.

In a further implementation form of the third aspect, the quadrature balanced power amplifier comprises one input coupler, two power amplifiers and one output coupler.

Thereby it is possible, for example, to achieve a simple configuration of the quadrature balanced power amplifier.

In a further implementation form of the third aspect, the quadrature balanced power amplifier comprises more than one input coupler. An input of a first input coupler is connected to the transmit signal input port. The remaining input couplers are arranged so that an input of each of the remaining input couplers is respectively connected to a respective output of another one of the remaining input couplers to obtain a tree-structure of the input couplers.

Thereby it is possible, for example, to increase the output power available from the quadrature balanced power amplifier.

In a further implementation form of the third aspect, hybrid couplers are used for the input and/or output couplers, and/or the input and/or output couplers are integrated on a substrate or a semiconductor chip.

Thereby it is possible, for example, to further reduce the size of the radio frequency front end.

In a further implementation form of the third aspect, the power amplifiers are designed to have a high output reflection coefficient.

Thereby it is possible, for example, to reduce the input loss of the signal path between an antenna and the receive signal input.

In a further implementation form of the third aspect, the receive path comprises an input amplifier used to amplify the receive signal, and a signal input of the input amplifier is connected to the output isolated port of the quadrature balanced power amplifier.

Thereby it is possible, for example, to amplify the receive signal before it is further processed.

In a further implementation form of the third aspect, the input amplifier is a low noise amplifier.

Thereby it is possible, for example, to achieve an improved signal-to-noise ratio of the amplified receive signal.

In a further implementation form of the third aspect, an input impedance of the input amplifier is matched to the characteristic impedance of the radio frequency front end.

Thereby it is possible, for example, to ensure a good operation of the quadrature balanced power amplifier with a high cancellation of a transmit signal at the output isolated port.

In a further implementation form of the third aspect, the quadrature balanced power amplifier further has an input isolated port.

Thereby it is possible, for example, to optimize the operation conditions of the quadrature balanced power amplifier.

In a further implementation form of the third aspect, a termination element having an impedance matching the characteristic impedance of the radio frequency front end is connected to the input isolated port.

Thereby it is possible, for example, to ensure a good operation of the quadrature balanced power amplifier with a high cancellation of a transmit signal at the output isolated port.

In a further implementation form of the third aspect, an antenna is connected to the transmit signal output port.

Thereby it is possible, for example, to transmit a transmit signal and receive the receive signal via the same antenna.

It shall further be understood that an embodiment of the invention can also be any combination of the dependent claims or above implementation forms with the respective independent claims or above aspects.

These and other aspects of the invention will be apparent and elucidated with reference to the embodiments described hereinafter.

### BRIEF DESCRIPTION OF THE DRAWINGS

- Fig. 1: is a block diagram of a radio frequency front end according to an embodiment of the present invention, wherein
- Fig. 1a: shows a circuit structure,
- Fig. 1b: shows a signal flow for a transmitting operation, and
- Fig. 1c: shows a signal flow for a receiving operation.
- Fig. 2: is a schematic block diagram of a modification of a quadrature balanced power amplifier used in the radio frequency front end front end according to the present invention.

### DETAILED DESCRIPTION

In the following, an embodiment of the invention is described with reference to the enclosed figures.

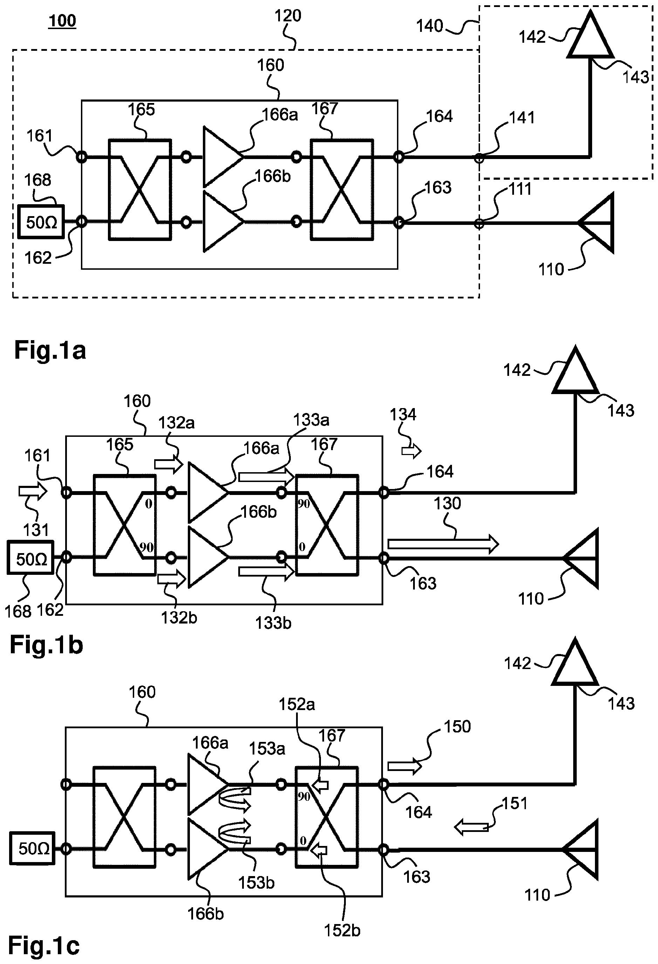

Fig. 1a shows a block diagram of a radio frequency front end for wireless communication according to the present embodiment. The radio frequency front end 100 comprises a transmit path 120 and a receive path 140. The radio frequency front end 100 further comprises an antenna port 111 to which an antenna 110 is connected.

The transmit path 120 comprises a quadrature balanced power amplifier 160. The quadrature balanced power amplifier 160 has four ports: a signal input port 161, an input isolated port 162, a signal output port 163, and an output isolated port 164. The signal output port 163 is connected to the antenna port 111.

The quadrature balanced power amplifier 160 further comprises an input coupler 165, two power amplifiers 166a, 166b, and an output coupler 167. A first input of the input coupler 165 is connected to the signal input port 161, and a second input is connected to the input isolated port 162. A first output of the input coupler 165 is connected to an input of the first power amplifier 166a, and a second output of the input coupler 165 is connected to an input of the second power amplifier 166b. An output of the first power amplifier 166a is connected to a first input of the output coupler 167, and an output of the second power amplifier 166b is connected to a second input of the output coupler 167. A first output of the output coupler 167 is connected to the signal output port 163, and a second output of the output coupler 167 is connected to the output isolated port 164. A termination element 168 is connected to the input isolated port 162.

The receive path 140 comprises a antenna141 which is connected to the output isolated port 164, and an input amplifier 142. The input amplifier 142 may be a low noise amplifier in order to be capable of processing even small signals with a sufficient signal-to-noise ratio. A signal input 143 of the input amplifier 142 is connected to the receive signal input 141 of the receive path 140.

Fig. 1b shows the block diagram of Fig. 1a with a signal flow for a transmitting operation of the radio frequency front end 100. In order to generate a transmit signal 130 which is supplied to and radiated by the antenna 110, an input signal 131 is supplied to the signal input port 161 of the balanced power amplifier 160 and thereby to the input coupler 165 which in the present case operates as a signal divider.

The input coupler 165 may be a 3dB/90° coupler that operates as follows: The input signal 131 is divided into two coupler output signals 132a, 132b having the same amplitude. Each of the coupler output signals 132a, 132b such has a signal level reduced by 3dB with regard to the input signal 131. Further, the second coupler output signal 132b has a relative phase of 90° compared with the phase of the first coupler output signal 132a.

For an optimum operation of the input coupler 165, all its inputs and outputs should be connected to an impedance matching the characteristic impedance of the input coupler 165. In RF technology, the characteristic impedances of all circuits and transmission lines used generally is 50Ω. For this purpose, the unused port of the input coupler 165 which is connected to the input isolated port 162 is terminated by the termination element 168 which in the present case also has an impedance of 50Ω.

Each of the coupler output signals 132a, 132b is then supplied to an input of a corresponding power amplifier 166a, 166b. The power amplifiers 166a, 166b amplify the coupler output signals 132a, 132b to obtain amplified signals 133a, 133b. The amplification factors or gains of the two power amplifiers 166a, 166b may have the same magnitude and phase so that also the two amplified signals 133a, 133b have the same amplitude and a phase difference of 90°. The two amplified signals 133a, 133b are then supplied to the two inputs of the output coupler 167 which in the present case operates as a signal combiner.

The output coupler 167 may be a 3dB/90° coupler that operates as follows: In a similar way as in the input coupler 165, the two amplified signals 133a, 133b are divided each into two components having the same amplitude and a phase shift of 90° with regard to each other.

At the signal output port 163, the components of both the amplified signals 133a, 133b have been subjected to one phase shift by 0° and one phase shift of 90°. They therefore are in phase and constructively interfere with each other to form by their addition the transmit signal 130. The transmit signal 130 thus has an amplitude greater than each of the amplified signals 133a, 133b by 3dB. In total, the transmit signal 130 corresponds to the input signal 130, amplified by the amplification factor of the power amplifiers 166a, 166b.

At the output isolated port 164, however, the component of the first amplified signal 133a has twice been subjected to a relative phase shift of 0°, and the component of the second amplified signal 133b has twice been subjected to a relative phase shift of 90°. Therefore, the two components have a phase difference of 180° and destructively interfere with each other to cancel each other. Due to irregularities and asymmetries, the cancellation needs not be complete. In any case, however, only a reduced signal 134 having a significantly lower amplitude than the transmit signal 130 is output from the output isolated port 164.

The radio frequency front end thereby achieves the effect that a significant isolation is provided between the transmit signal 130 and the receive signal input of the receive path 140. No further element such as a signal switch or a circulator is required for this purpose.

Fig. 1c shows the block diagram of Fig. 1a with a signal flow for a receiving operation of the radio frequency front end 100. In order to generate a receive signal 150 which is supplied to and processed by the receive path 140, a signal 151 received from the antenna 110 is supplied to the transmit signal output port 163 of the quadrature balanced power amplifier 160 and thereby to the output coupler 167 which in the present case is operated in the backwards direction and therefore functions as a signal divider.

Similar as described above for the input coupler 165 in the transmit operation, the output coupler 167 in the receive operation divides the signal 151 received from the antenna 110 into two incoming signals 152a, 152b having the same amplitude and a phase difference of 90°. Each of the coupler output signals 132a, 132b is then supplied to an output of a corresponding power amplifier 166a, 166b.

Power amplifiers, for example amplifiers employing power transistors, generally have a high reflection coefficient which is equal to a low reflection loss. Since power amplifiers generally are operated near saturation in order to achieve an output power as high as possible, not only the small signal reflection coefficient needs to be regarded, but especially a large signal reflection coefficient.

The power amplifiers 166a, 166b used for the present invention may also especially be designed to have a large output reflection coefficient not only at small signal operation, but also at large signal operation.

The incoming signals 152a, 152b are therefore largely reflected back at the outputs of the power amplifiers 166a, 166b to obtain reflected signals 153a, 153b. The reflection coefficients of the two power amplifiers 166a, 166b may have the same magnitude and phase so that also the two reflected signals 153a, 153b have the same amplitude and a relative phase difference of 90°. The reflected signals 153a, 153b propagate back to the output coupler 167 which now is operated in the forwards direction and therefore functions as a signal combiner in the same way as described above for the transmit operation. That means that also the two reflected signals 153a, 153b are divided each into two components having the same amplitude and a relative phase shift of 90° with regard to each other.

In the receive operation, however, the components of the reflected signals 153a, 153b at the output isolated port 164 have each been subjected to one relative phase shift of 0° and one relative phase shift of 90°. They therefore are in phase and constructively interfere with each other to form by their addition the receive signal 150. In an ideal case where the output reflection coefficients of the power amplifiers 166a, 166b have an absolute value of 1, meaning total reflection or no reflection loss, the receive signal 150 equals the signal 151 received from the antenna 110. Otherwise, a slight loss will have to be taken into account.

Since the output isolated port 164 is connected to the receive signal input 141 of the receive path 140, it is possible to supply signal 151 received from the antenna 110 to the receive signal input 141 of the receive path 140 with no or only a small loss. For an optimum operation of the output coupler 167, all its inputs and outputs should be connected to an impedance matching the characteristic impedance of the output coupler 167. Therefore, an input impedance of the input amplifier 142 and thus of the receive path 140 is matched to the characteristic impedance.

The output isolated port 164 is connected directly to the receive signal input 141, needing neither use of a dedicated isolation device or circuit nor of an isolation switch. Even if no bulky, expensive, or wavelength-sensitive components such as signal switch or a circulator is used, a significant isolation is nevertheless provided between the transmit signal 130 and the receive signal input of the receive path 140, as described above.

The radio frequency front end thereby achieves the effect that in a wireless communication in which transmitting and receiving is performed using the same antenna a sufficient isolation between the transmit path and the receive path can be provided without the need of bulky elements or without the restriction to a small bandwidth. Further, no elements restricting the power handling are required. Further, a low insertion loss on the transmit path and receive path can be achieved.

Further, all the components of the radio frequency front end are capable of being integrated on a RF printed circuit board or substrate as well as with Monolithic Microwave Integrated Circuits or Radio Frequency Integrated Circuits. Thereby, a small size (especially a reduced height) and a low weight may be achieved. Further, the costs for such a radio frequency front end can be reduced, especially if it is integrated.

Different integration technologies may be used for integrating the couplers, for example a branch line on an RF board (yielding about 10% bandwidth), Lang couplers on an RF board, on Monolithic Microwave Integrated Circuits or on Radio Frequency Integrated Circuits (yielding a wide bandwidth), 3 dB Coupled lines on ceramics or on Radio Frequency Integrated Circuits (yielding a wide bandwidth) or lumped elements in different technologies. For solutions in which the isolation is similar to ferrite circulators (about 20 dB), bandwidth and insertion loss in most implementations may be improved.

An example shows that a size reduction can even be achieved when hybrid integrated couplers and discrete power amplifier ICs are used.

A conventional circulator for 2.4 GHz, for example SDC1721 , has a print size of 19 mm x 19 mm and a height of 6.35 mm. It offers an insulation of 18 dB with an insertion loss of -0.5 dB for transmission and of -0.5 dB for reception.

For a radio frequency front at 2.4 GHz end according to the embodiment, two hybrid integrated couplers of the type XC2500E-03 and two power amplifiers of the type HMC457QS16G may be used, for example. The XC2500E-03 has a print size of 14 mm x 5 mm, a height of 1.75 mm, a coupler insertion loss of -0.15 dB and a coupler isolation of -22 dB. The HMC457QS16G has a print size of 5 mm x 6 mm, a height of 1.75 mm, and an output return loss of -1dB. Taking the coupler insertion loss twice since the signal bot in transmission as in reception mode twice propagates through a coupler, and adding the output return loss in the reception mode, this results in an insulation of 22 dB with an insertion loss of -0.3 dB for transmission and of -1.3 dB for reception. The print size is reduced to about a half, the height to about a quarter of the circulator solution.

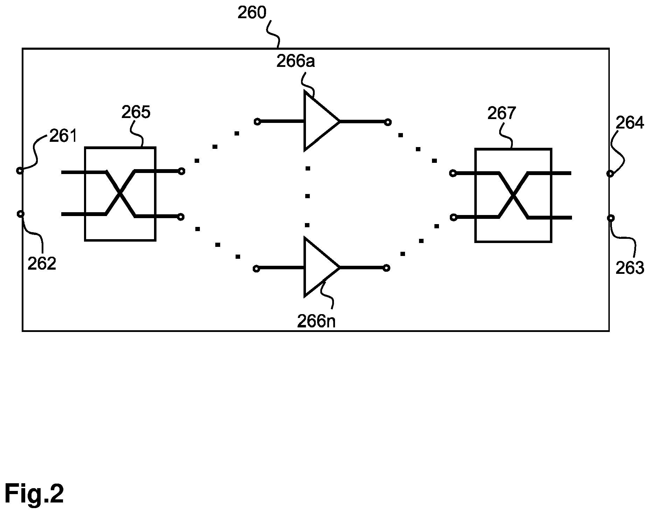

The quadrature balanced power amplifier that may be used for the radio frequency front end is not restricted to the example described in the embodiment. Fig. 2 shows a schematic block diagram of a modification of the quadrature balanced power amplifier described above.

Similar as the quadrature balanced power amplifier 160 described above, the quadrature balanced power amplifier 260 shown in Fig. 2 has a signal input port 261, an input isolated port 262, a signal output port 263, and an output isolated port 264. It further comprises an input coupler 265 and an output coupler 267. It differs from the quadrature balanced power amplifier 160 in that it further comprises a predetermined number n of power amplifiers 266a-266n. Those power amplifiers may for example be divided into two groups, wherein the power amplifiers of the same group are connected in parallel, for example by directly connecting the inputs in parallel and by connecting the outputs in parallel, or by using equal phase dividers and combiners at the input and output side, respectively. Each of the two groups of power amplifiers such corresponds to one of the power amplifiers 166a, 166b of Fig. 1a.

On the other hand, the quadrature balanced power amplifier 260 may further comprise additional input and output couplers which are not shown in the figure, but only schematically symbolized by an ellipsis. The additional input and output couplers are arranged in a way that a signal supplied to the signal input port 261 is divided in more than two coupler output signals, each of which is amplified by a corresponding power amplifier 266a-266n (or by a group of power amplifiers connected in parallel, as described above), and that the resulting amplified signals are combined to form a transmit signal at the signal output port 263 and to cancel each other at the output isolated port 264. It also has to be made sure that a signal received by the antenna and supplied to the signal output port 263 is sufficiently reflected by the stages before a final combiner constructively adds at the output isolated port 264 to form the receive signal supplied to the receive path.

For example, the additional input couplers may be arranged so that an input of each of the additional input couplers is respectively connected to a respective output of another one of the input couplers to obtain a tree-structure of the input couplers.

Also the effects of such a quadrature balanced power amplifier 260 are the same as indicated above, while a larger output power can be achieved.

In summary, the present invention relates to a radio frequency front end for wireless communication, especially to a radio frequency front end in which transmitting and receiving is performed using the same antenna. The front end comprises an antenna port adapted to connect the antenna, a receive path comprising a receive signal input adapted to receive a receive signal, and a transmit path adapted to supply a transmit signal to the antenna port, the transmit path comprising a quadrature balanced power amplifier having a transmit signal output port connected to the antenna port and an output isolated port connected to the receive signal input.

While the present invention has been illustrated and described in detail in the drawings and the foregoing description, such illustration and description are to be considered illustrative or exemplary and not restrictive. The invention is not limited to the disclosed embodiments. From reading the present disclosure, other modifications will be apparent to a person skilled in the art. Such modifications may involve other features, which are already known in the art and may be used instead of or in addition to features already described herein.

The invention has been described in conjunction with various embodiments herein. However, other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Although the present invention has been described with reference to specific features and embodiments thereof, it is evident that various modifications and combinations can be made thereto without departing from the scope of the invention. The specification and drawings are, accordingly, to be regardec simply as an illustration of the invention as defined by the appended claims.

## Claims

1. A method for performing single-antenna wireless communication in a radio frequency front end (100), the method comprising transmitting, in a transmitting operation of the radio frequency front end (100), a transmit signal (130) via an antenna (110) connected to an antenna port (111) and receiving, in a receiving operation of the radio frequency front end (100), a receive signal (150) via the same antenna (110), wherein receiving the receive signal (150) in the receiving operation comprises
supplying a signal (151) received from the antenna (110) to a transmit signal output port (163) of a quadrature balanced power amplifier (160) having said transmit signal output port (163) and an output isolated port (164), and
supplying an output signal of said output isolated port (164) as the receive signal (150) to a receive signal input (141) of a receive path (140) adapted to process the receive signal (150);
suppling, in the transmitting operation, by a transmit path (120), a transmit signal (130) to the antenna port (111), the transmit path (120) comprising the quadrature balanced power amplifier (160) having said transmit signal output port (163) connected to the antenna port (111) and said output isolated port (164) connected to the receive signal input (141); and
receiving, in the transmitting operation, at a send signal input port (161), an input signal (131),
dividing, by an input coupler (165) of the quadrature balanced power amplifier (160), the input signal (131) into at least two coupler output signals (132a, 132b),
amplifying, by two power amplifiers (166a, 166b) of the quadrature balanced power amplifier (160) the two coupler output signals (132a, 132b) to obtain a respective amplified signal (133a, 133b),
the input coupler dividing the input signal and an output coupler (167) connected to the send signal output port (163) and the output isolated port (164) of the quadrature balanced power amplifier (160) combining the amplified signals (133a, 133b) so that components of both amplified signals (133a, 133b) have been subjected to one phase shift of 0° and one phase shift of 90° and the amplified signals (133a, 133b) are in phase and constructively interfere with each other at the send signal output port (163)
and the input coupler and the output coupler (167) dividing the input signal (131) and combining the amplified signals (133a, 133b), respectively, so that a component of a first amplified signal (133a) of one power amplifier (166a) has been subjected twice to a relative phase shift of 0° and so that a component of a second amplified signal (133b) of the other power amplifier (166b) has been subjected twice to a relative phase shift of 90° so that the amplified signals (133a, 133b) have a phase difference of 180° and destructively interfere with each other at the output isolated port (164); and
wherein in the receiving operation of the radio frequency front end (100), when a signal (151) is received from the antenna (110), the signal (151) is supplied to the transmit signal output port (163) of the quadrature balanced power amplifier (160) and thereby to the output coupler (167) adapted to operate as a signal divider to divide the signal (151) received from the antenna (110) into two incoming signals (152a, 152b) having the same amplitude and a phase difference of 90° each supplied to an output of a corresponding power amplifier (166a, 166b) where the incoming signals 152a, 152b are reflected back at the outputs of the power amplifiers (166a, 166b) to obtain two reflected signals (153a, 153b) having the same amplitude and a relative phase difference of 90°, wherein the two reflected signals (153a, 153b) propagate back to the output coupler (167) operated in the forward direction and functioning as a signal combiner adapted to divide the two reflected signals (153a, 153b) into two components having the same amplitude and a relative phase shift of 90° with regard to each other such that the components of the two reflected signals (153a, 153b) at the output isolated port (164) connected to the receive signal input (141) are each subjected to one relative phase shift of 0° and one relative phase shift of 90° such that they are in phase and constructively interfere with each other to generate by their addition the receive signal (150) at the receive signal input (141).

2. The method according to claim 1, wherein
the at least one output coupler (167) is adapted to combine the amplified signals (133a, 133b) in a way that the transmit signal (130) formed at the transmit signal output port (163) is an amplified input signal (131) and/or
the at least one output coupler (167) is adapted to combine the amplified signals (133a, 133b) in a way that a signal (134) formed at the transmit output isolated port (164) is reduced in its amplitude with respect to the transmit signal (130).

3. The method according to claim 1 or 2, wherein
each input coupler (165) is adapted to divide a signal into two coupler output signals (132a, 132b) having a power reduced by 3dB and a phase difference of 90° between each other.

4. The method according to any of claims 1 to 3, wherein
the quadrature balanced power amplifier (160) comprises one input coupler (165), two power amplifiers (166a, 166b) and one output coupler (167).

5. The method according to any of claims 1 to 3, wherein
the quadrature balanced power amplifier comprises more than one input coupler (165), wherein
an input of a first input coupler is connected to the transmit signal input port, and
the remaining input couplers are arranged so that an input of each of the remaining input couplers is respectively connected to a respective output of another one of the remaining input couplers to obtain a tree-structure of the input couplers.

6. The method according to any of claims 1 to 5, wherein
hybrid couplers are used for the input and/or output couplers (165, 167), and/or
the input and/or output couplers (165, 167) are integrated on a substrate or a semiconductor chip.

7. The method according to any of claims 1 to 6, wherein the power amplifiers (166a, 166b) are designed to have a high output reflection coefficient.

8. The method according to any of claims 1 to 7, wherein
the receive path (140) comprises an input amplifier (142) adapted to amplify the receive signal (150), and
a signal input (143) of the input amplifier (142) is connected to the output isolated port (164) of the quadrature balanced power amplifier (160).

9. The method according to claim 8, wherein
the input amplifier (142) is a low noise amplifier and/or
an input impedance of the input amplifier (142) is matched to the characteristic impedance of the radio frequency front end (100).

10. The method according to any of claims 1 to 9, wherein the quadrature balanced power amplifier (160) further has an input isolated port (162).

11. The method according to claim 10, wherein a termination element (168) having an impedance matching the characteristic impedance of the radio frequency front end (100) is connected to the input isolated port (162).

12. The method according to any of claims 1 to 11, wherein an antenna (110) is connected to the antenna port (111).

13. A radio frequency front end (100) for wireless communication, the front end comprising:
an antenna port (111) adapted to connect an antenna (110),
a receive path (140) comprising a receive signal input (141) adapted to generate a receive signal (150) in a receiving operation of the radio frequency front end (100), and
a transmit path (120) adapted to supply a transmit signal (130) to the antenna port (111), the transmit path (120) comprising a quadrature balanced power amplifier (160) having a transmit signal output port (163) connected to the antenna port (111) and an output isolated port (164) connected to the receive signal input (141); and wherein the quadrature balanced power amplifier (160) further comprises:
a send signal input port (161) adapted to receive an input signal (131) in a transmitting operation of the radio frequency front end (100),
an input coupler (165) adapted to divide the input signal (131) into two coupler output signals (132a, 132b) in the transmitting operation,
two power amplifiers (166a, 166b), each power amplifier (166a, 166b) being adapted to amplify one of the two coupler output signals (132a, 132b) to obtain a respective amplified signal (133a, 133b),
an output coupler (167) connected to the send signal output port (163) and the output isolated port (164) of the quadrature balanced power amplifier (160),
wherein the input coupler (165) and the output coupler (167) are adapted to divide the transmit signal (131) and combine the amplified signals (133a, 133b), respectively, so that components of both amplified signals (133a, 133b) have been subjected to one phase shift of 0° and one phase shift of 90° and the amplified signals (133a, 133b) are in phase and constructively interfere with each other at the send signal output port (163),
and the input coupler (165) and the output coupler (167) are adapted to divide the transmit signal (131) and combine the amplified signals (133a, 133b), respectively, so that a component of a first amplified signal (133a) of one power amplifier (166a) has been subjected twice to a relative phase shift of 0° and so that a component of a second amplified signal (133b) of the other power amplifier (166b) has been subjected twice to a relative phase shift of 90°and the amplified signals (133a, 133b) have a phase difference of 180° and destructively interfere with each other at the output isolated port (164); and
wherein in the receiving operation of the radio frequency front end (100), when a signal (151) is received from the antenna (110), the signal (151) is supplied to the transmit signal output port (163) of the quadrature balanced power amplifier (160) and thereby to the output coupler (167) adapted to operate as a signal divider to divide the signal (151) received from the antenna (110) into two incoming signals (152a, 152b) having the same amplitude and a phase difference of 90° each supplied to an output of a corresponding power amplifier (166a, 166b) where the incoming signals 152a, 152b are reflected back at the outputs of the power amplifiers (166a, 166b) to obtain two reflected signals (153a, 153b) having the same amplitude and a relative phase difference of 90°, wherein the two reflected signals (153a, 153b) propagate back to the output coupler (167) operated in the forward direction and functioning as a signal combiner adapted to divide the two reflected signals (153a, 153b) into two components having the same amplitude and a relative phase shift of 90° with regard to each other such that the components of the two reflected signals (153a, 153b) at the output isolated port (164) connected to the receive signal input (141) are each subjected to one relative phase shift of 0° and one relative phase shift of 90° such that they are in phase and constructively interfere with each other to generate by their addition the receive signal (150) at the receive signal input (141).

14. The radio frequency front end (100) according to claim 13, wherein
the at least one output coupler (167) is adapted to combine the amplified signals (133a, 133b) in a way that the transmit signal (130) formed at the transmit signal output port (163) is an amplified input signal (131) and/or
the at least one output coupler (167) is adapted to combine the amplified signals (133a, 133b) in a way that a signal (134) formed at the transmit output isolated port (164) is reduced in its amplitude with respect to the transmit signal (130).

15. The radio frequency front end (100) according to claim 13 or 14, wherein
each input coupler (165) is adapted to divide a signal into two coupler output signals (132a, 132b) having a power reduced by 3dB and a phase difference of 90° between each other.

## Patentansprüche

1. Verfahren zum Durchführen einer drahtlosen Kommunikation mit einer einzelnen Antenne in einem Hochfrequenz-Frontend (100), wobei das Verfahren Übertragen, in einem Übertragungsvorgang des Hochfrequenz-Frontends (100), eines Übertragungssignals (130) über eine Antenne (110), die mit einem Antennenanschluss (111) verbunden ist, und Empfangen, in einem Empfangsvorgang des Hochfrequenz-Frontends (100), eines Empfangssignals (150) über dieselbe Antenne (110) umfasst, wobei das Empfangen des Empfangssignals (150) in dem Empfangsvorgang Folgendes umfasst
Übermitteln eines von der Antenne (110) empfangenen Signals (151) an einen Übertragungssignalausgangsanschluss (163) eines symmetrischen Quadraturleistungsverstärkers (160), der den Übertragungssignalausgangsanschluss (163) und einen isolierten Ausgangsanschluss (164) aufweist, und
Übermitteln eines Ausgangssignals des isolierten Ausgangsanschlusses (164) als das Empfangssignal (150) an einen Empfangssignaleingang (141) eines Empfangspfads (140), der dazu ausgelegt ist, das Empfangssignal (150) zu verarbeiten;
Übermitteln, in dem Übertragungsvorgang, durch einen Übertragungspfad (120), eines Übertragungssignals (130) an den Antennenanschluss (111), wobei der Übertragungspfad (120) den symmetrischen Quadraturleistungsverstärker (160) umfasst, der den Übertragungssignalausgangsanschluss (163), der mit dem Antennenanschluss (111) verbunden ist, und den isolierten Ausgangsanschluss (164), der mit dem Empfangssignaleingang (141) verbunden ist, aufweist; und
Empfangen, in dem Übertragungsvorgang, an einem Sendesignaleingangsanschluss (161), eines Eingangssignals (131),
Teilen, durch einen Eingangskoppler (165) des symmetrischen Quadraturleistungsverstärkers (160), des Eingangssignals (131) in mindestens zwei Kopplerausgangssignale (132a, 132b),
Verstärken, durch zwei Leistungsverstärker (166a, 166b) des symmetrischen Quadraturleistungsverstärkers (160), der zwei Kopplerausgangssignale (132a, 132b), um ein jeweiliges verstärktes Signal (133a, 133b) zu erhalten,
wobei der Eingangskoppler das Eingangssignal teilt und ein Ausgangskoppler (167), der mit dem Sendesignalausgangsanschluss (163) und dem isolierten Ausgangsanschluss (164) des symmetrischen Quadraturleistungsverstärkers (160) verbunden ist, die verstärkten Signale (133a, 133b) kombiniert, so dass Komponenten beider verstärkter Signale (133a, 133b) einer Phasenverschiebung von 0° und einer Phasenverschiebung von 90° unterzogen wurden und die verstärkten Signale (133a, 133b) in Phase sind und an dem Sendesignalausgangsanschluss (163) konstruktiv miteinander interferieren
und wobei der Eingangskoppler und der Ausgangskoppler (167) das Eingangssignal (131) teilt bzw. die verstärkten Signale (133a, 133b) kombiniert, so dass eine Komponente eines ersten verstärkten Signals (133a) eines Leistungsverstärkers (166a) zweimal einer relativen Phasenverschiebung von 0° unterzogen wurde und so dass eine Komponente eines zweiten verstärkten Signals (133b) des anderen Leistungsverstärkers (166b) zweimal einer relativen Phasenverschiebung von 90° unterzogen wurde, so dass die verstärkten Signale (133a, 133b) eine Phasendifferenz von 180° aufweisen und an dem isolierten Ausgangsanschluss (164) destruktiv miteinander interferieren; und
wobei in dem Empfangsvorgang des Hochfrequenz-Frontends (100), wenn ein Signal (151) von der Antenne (110) empfangen wird, das Signal (151) zu dem Übertragungssignalausgangsanschluss (163) des symmetrischen Quadraturleistungsverstärkers (160) und dadurch zu dem Ausgangskoppler (167) übermittelt wird, der dazu ausgelegt ist, als ein Signalteiler betrieben zu werden, um das von der Antenne (110) empfangene Signal (151) in zwei eingehende Signale (152a, 152b), die dieselbe Amplitude und eine Phasendifferenz von 90° aufweisen, zu teilen, die jeweils zu einem Ausgang eines entsprechenden Leistungsverstärkers (166a, 166b) übermittelt werden, wobei die eingehenden Signale 152a, 152b an den Ausgängen der Leistungsverstärker (166a, 166b) zurück reflektiert werden, um zwei reflektierte Signale (153a, 153b) zu erhalten, die dieselbe Amplitude und eine relative Phasendifferenz von 90° aufweisen, wobei die zwei reflektierten Signale (153a, 153b) sich zurück zu dem Ausgangskoppler (167) ausbreiten, der in der Vorwärtsrichtung betrieben wird und als ein Signalkombinierer funktioniert, der dazu ausgelegt ist, die zwei reflektierten Signale (153a, 153b) in zwei Komponenten zu teilen, die dieselbe Amplitude und eine relative Phasenverschiebung von 90° in Bezug aufeinander aufweisen, so dass die Komponenten der zwei reflektierten Signale (153a, 153b) an dem isolierten Ausgangsanschluss (164), der mit dem Empfangssignaleingang (141) verbunden ist, jeweils einer relativen Phasenverschiebung von 0° und einer relativen Phasenverschiebung von 90° unterzogen werden, so dass sie in Phase sind und konstruktiv miteinander interferieren, um durch ihre Addition das Empfangssignal (150) an dem Empfangssignaleingang (141) zu erzeugen.

2. Verfahren nach Anspruch 1, wobei
der mindestens eine Ausgangskoppler (167) dazu ausgelegt ist, die verstärkten Signale (133a, 133b) auf eine Weise zu kombinieren, dass das Übertragungssignal (130), das an dem Übertragungssignalausgangsanschluss (163) ausgebildet wird, ein verstärktes Eingangssignal (131) ist, und/oder
der mindestens eine Ausgangskoppler (167) dazu ausgelegt ist, die verstärkten Signale (133a, 133b) auf eine Weise zu kombinieren, dass ein Signal (134), das an dem isolierten Übertragungsausgangsanschluss (164) ausgebildet wird, in seiner Amplitude in Bezug auf das Übertragungssignal (130) reduziert ist.

3. Verfahren nach Anspruch 1 oder 2, wobei
jeder Eingangskoppler (165) dazu ausgelegt ist, ein Signal in zwei Kopplerausgangssignale (132a, 132b) zu teilen, die eine um 3 dB reduzierte Leistung und eine Phasendifferenz von 90° zwischen einander aufweisen.

4. Verfahren nach einem der Ansprüche 1 bis 3, wobei
der symmetrische Quadraturleistungsverstärker (160) einen Eingangskoppler (165), zwei Leistungsverstärker (166a, 166b) und einen Ausgangskoppler (167) umfasst.

5. Verfahren nach einem der Ansprüche 1 bis 3, wobei
der symmetrische Quadraturleistungsverstärker mehr als einen Eingangskoppler (165) umfasst, wobei
ein Eingang eines ersten Eingangskopplers mit dem Übertragungssignaleingangsanschluss verbunden ist, und
die restlichen Eingangskoppler derart angeordnet sind, dass ein Eingang jedes der restlichen Eingangskoppler jeweils mit einem jeweiligen Ausgang eines anderen der restlichen Eingangskoppler verbunden ist, um eine Baumstruktur der Eingangskoppler zu erhalten.

6. Verfahren nach einem der Ansprüche 1 bis 5, wobei
hybride Koppler für die Eingangs- und/oder Ausgangskoppler (165, 167) verwendet werden, und/oder
die Eingangs- und/oder Ausgangskoppler (165, 167) auf einem Substrat oder einem Halbleiterchip integriert sind.

7. Verfahren nach einem der Ansprüche 1 bis 6, wobei die Leistungsverstärker (166a, 166b) so ausgestaltet sind, dass sie einen hohen Ausgangsreflexionskoeffizienten aufweisen.

8. Verfahren nach einem der Ansprüche 1 bis 7, wobei
der Empfangspfad (140) einen Eingangsverstärker (142) umfasst, der dazu ausgelegt ist, das Empfangssignal (150) zu verstärken, und
ein Signaleingang (143) des Eingangsverstärkers (142) mit dem isolierten Ausgangsanschluss (164) des symmetrischen Quadraturleistungsverstärkers (160) verbunden ist.

9. Verfahren nach Anspruch 8, wobei
der Eingangsverstärker (142) ein rauscharmer Verstärker ist und/oder eine Eingangsimpedanz des Eingangsverstärkers (142) auf eine Kennimpedanz des Hochfrequenz-Frontends (100) abgestimmt ist.

10. Verfahren nach einem der Ansprüche 1 bis 9, wobei der symmetrische Quadraturleistungsverstärker (160) ferner einen isolierten Eingangsanschluss (162) aufweist.

11. Verfahren nach Anspruch 10, wobei ein Abschlusselement (168), das eine Impedanz aufweist, die auf die Kennimpedanz des Hochfrequenz-Frontends (100) abgestimmt ist, mit dem isolierten Eingangsanschluss (162) verbunden ist.

12. Verfahren nach einem der Ansprüche 1 bis 11, wobei eine Antenne (110) mit dem Antennenanschluss (111) verbunden ist.

13. Hochfrequenz-Frontend (100) für drahtlose Kommunikation, wobei das Frontend Folgendes umfasst:
einen Antennenanschluss (111), der dazu ausgelegt ist, eine Antenne (110) zu verbinden,
einen Empfangspfad (140), der einen Empfangssignaleingang (141) umfasst, der dazu ausgelegt ist, ein Empfangssignal (150) in einem Empfangsvorgang des Hochfrequenz-Frontends (100) zu erzeugen, und
einen Übertragungspfad (120), der dazu ausgelegt ist, ein Übertragungssignal (130) an den Antennenanschluss (111) zu übermitteln, wobei der Übertragungspfad (120) einen symmetrischen Quadraturleistungsverstärker (160) umfasst, der einen Übertragungssignalausgangsanschluss (163), der mit dem Antennenanschluss (111) verbunden ist, und einen isolierten Ausgangsanschluss (164), der mit dem Empfangssignaleingang (141) verbunden ist, aufweist; und
wobei der symmetrische Quadraturleistungsverstärker (160) ferner Folgendes umfasst:
einen Sendesignaleingangsanschluss (161), der dazu ausgelegt ist, ein Eingangssignal (131) in einem Übertragungsvorgang des Hochfrequenz-Frontends (100) zu empfangen,
einen Eingangskoppler (165), der dazu ausgelegt ist, in dem Übertragungsvorgang das Eingangssignal (131) in zwei Kopplerausgangssignale (132a, 132b) zu teilen,
zwei Leistungsverstärker (166a, 166b), wobei jeder Leistungsverstärker (166a, 166b) dazu ausgelegt ist, eines der zwei Kopplerausgangssignale (132a, 132b) zu verstärken, um ein jeweiliges verstärktes Signal (133a, 133b) zu erhalten,
einen Ausgangskoppler (167), der mit dem Sendesignalausgangsanschluss (163) und dem isolierten Ausgangsanschluss (164) des symmetrischen Quadraturleistungsverstärkers (160) verbunden ist,
wobei der Eingangskoppler (165) und der Ausgangskoppler (167) dazu ausgelegt sind, das Übertragungssignal (131) zu teilen bzw. die verstärkten Signale (133a, 133b) zu kombinieren, so dass Komponenten beider verstärkter Signale (133a, 133b) einer Phasenverschiebung von 0° und einer Phasenverschiebung von 90° unterzogen wurden und die verstärkten Signale (133a, 133b) in Phase sind und an dem Sendesignalausgangsanschluss (163) konstruktiv miteinander interferieren,
und wobei der Eingangskoppler (165) und der Ausgangskoppler (167) dazu ausgelegt sind, das Übertragungssignal (131) zu teilen bzw. die verstärkten Signale (133a, 133b) zu kombinieren, so dass eine Komponente eines ersten verstärkten Signals (133a) eines Leistungsverstärkers (166a) zweimal einer relativen Phasenverschiebung von 0° unterzogen wurde und so dass eine Komponente eines zweiten verstärkten Signals (133b) des anderen Leistungsverstärkers (166b) zweimal einer relativen Phasenverschiebung von 90° unterzogen wurde und die verstärkten Signale (133a, 133b) eine Phasendifferenz von 180° aufweisen und an dem isolierten Ausgangsanschluss (164) destruktiv miteinander interferieren; und
wobei in dem Empfangsvorgang des Hochfrequenz-Frontends (100), wenn ein Signal (151) von der Antenne (110) empfangen wird, das Signal (151) zu dem Übertragungssignalausgangsanschluss (163) des symmetrischen Quadraturleistungsverstärkers (160) und dadurch zu dem Ausgangskoppler (167) übermittelt wird, der dazu ausgelegt ist, als ein Signalteiler betrieben zu werden, um das von der Antenne (110) empfangene Signal (151) in zwei eingehende Signale (152a, 152b), die dieselbe Amplitude und eine Phasendifferenz von 90° aufweisen, zu teilen, die jeweils zu einem Ausgang eines entsprechenden Leistungsverstärkers (166a, 166b) übermittelt werden, wobei die eingehenden Signale 152a, 152b an den Ausgängen der Leistungsverstärker (166a, 166b) zurück reflektiert werden, um zwei reflektierte Signale (153a, 153b) zu erhalten, die dieselbe Amplitude und eine relative Phasendifferenz von 90° aufweisen, wobei die zwei reflektierten Signale (153a, 153b) sich zurück zu dem Ausgangskoppler (167) ausbreiten, der in der Vorwärtsrichtung betrieben wird und als ein Signalkombinierer funktioniert, der dazu ausgelegt ist, die zwei reflektierten Signale (153a, 153b) in zwei Komponenten zu teilen, die dieselbe Amplitude und eine relative Phasenverschiebung von 90° in Bezug aufeinander aufweisen, so dass die Komponenten der zwei reflektierten Signale (153a, 153b) an dem isolierten Ausgangsanschluss (164), der mit dem Empfangssignaleingang (141) verbunden ist, jeweils einer relativen Phasenverschiebung von 0° und einer relativen Phasenverschiebung von 90° unterzogen werden, so dass sie in Phase sind und konstruktiv miteinander interferieren, um durch ihre Addition das Empfangssignal (150) an dem Empfangssignaleingang (141) zu erzeugen.

14. Hochfrequenz-Frontend (100) nach Anspruch 13, wobei
der mindestens eine Ausgangskoppler (167) dazu ausgelegt ist, die verstärkten Signale (133a, 133b) auf eine Weise zu kombinieren, dass das Übertragungssignal (130), das an dem Übertragungssignalausgangsanschluss (163) ausgebildet wird, ein verstärktes Eingangssignal (131) ist, und/oder
der mindestens eine Ausgangskoppler (167) dazu ausgelegt ist, die verstärkten Signale (133a, 133b) auf eine Weise zu kombinieren, dass ein Signal (134), das an dem isolierten Übertragungsausgangsanschluss (164) ausgebildet wird, in seiner Amplitude in Bezug auf das Übertragungssignal (130) reduziert ist.

15. Hochfrequenz-Frontend (100) nach Anspruch 13 oder 14, wobei jeder Eingangskoppler (165) dazu ausgelegt ist, ein Signal in zwei Kopplerausgangssignale (132a, 132b) zu teilen, die eine um 3 dB reduzierte Leistung und eine Phasendifferenz von 90° zwischen einander aufweisen.

## Revendications

1. Procédé de communication sans fil à antenne unique dans un module frontal radiofréquence (100), le procédé comprenant l'émission, dans une opération d'émission du module frontal radiofréquence (100), d'un signal d'émission (130) par l'intermédiaire d'une antenne (110) connectée à un port d'antenne (111) et la réception, dans une opération de réception du module frontal radiofréquence (100), d'un signal de réception (150) par l'intermédiaire de la même antenne (110), dans lequel la réception du signal de réception (150) dans l'opération de réception comprend les étapes suivantes :
fournir un signal (151) reçu de l'antenne (110) à un port de sortie de signal d'émission (163) d'un amplificateur de puissance équilibré en quadrature (160) ayant ledit port de sortie de signal d'émission (163) et un port isolé de sortie (164), et
fournir un signal de sortie dudit port isolé de sortie (164) en tant que signal de réception (150) à une entrée de signal de réception (141) d'un chemin de réception (140) adaptée pour traiter le signal de réception (150) ;
fournir, dans l'opération d'émission, par un chemin d'émission (120), un signal d'émission (130) au port d'antenne (111), le chemin d'émission (120) comprenant l'amplificateur de puissance équilibré en quadrature (160) ayant ledit port de sortie de signal d'émission (163) connecté au port d'antenne (111) et ledit port isolé de sortie (164) connecté à l'entrée de signal de réception (141) ; et
recevoir, dans l'opération d'émission, au niveau d'un port d'entrée de signal d'émission (161), un signal d'entrée (131),
diviser, par un coupleur d'entrée (165) de l'amplificateur de puissance équilibré en quadrature (160), le signal d'entrée (131) en au moins deux signaux de sortie de coupleur (132a, 132b),
amplifier, par deux amplificateurs de puissance (166a, 166b) de l'amplificateur de puissance équilibré en quadrature (160), les deux signaux de sortie de coupleur (132a, 132b) pour obtenir un signal amplifié respectif (133a, 133b),
le coupleur d'entrée divisant le signal d'entrée et un coupleur de sortie (167) connecté au port de sortie du signal d'envoi (163) et au port isolé de sortie (164) de l'amplificateur de puissance équilibré en quadrature (160) combinant les signaux amplifiés (133a, 133b) de sorte que les composantes des deux signaux amplifiés (133a, 133b) aient été soumises à un déphasage de 0° et à un déphasage de 90° et que les signaux amplifiés (133a, 133b) soient en phase et interfèrent de manière constructive l'un avec l'autre au niveau du port de sortie du signal d'émission (163),
et le coupleur d'entrée et le coupleur de sortie (167) divisant le signal d'entrée (131) et combinant les signaux amplifiés (133a, 133b), respectivement, de sorte qu'une composante du premier signal amplifié (133a) d'un amplificateur de puissance (166a) ait été soumise deux fois à un déphasage relatif de 0° et qu'une composante du deuxième signal amplifié (133b) de l'autre amplificateur de puissance (166b) ait été soumise deux fois à un déphasage relatif de 90° de sorte que les signaux amplifiés (133a, 133b) présentent une différence de phase de 180° et interfèrent de manière destructive l'un avec l'autre au niveau du port isolé de sortie (164) ; et
dans lequel, dans l'opération de réception du module frontal radiofréquence (100), lorsqu'un signal (151) est reçu de l'antenne (110), le signal (151) est fourni au port de sortie du signal d'émission (163) de l'amplificateur de puissance équilibré en quadrature (160) et donc au coupleur de sortie (167) adapté pour fonctionner comme diviseur de signal afin de diviser le signal (151) reçu de l'antenne (110) en deux signaux d'entrée (152a, 152b) ayant la même amplitude et une différence de phase de 90° chacun fourni à une sortie d'un amplificateur de puissance correspondant (166a, 166b) où les signaux entrants 152a, 152b sont réfléchis vers les sorties des amplificateurs de puissance (166a, 166b) pour obtenir deux signaux réfléchis (153a, 153b) ayant la même amplitude et une différence de phase relative de 90°, dans lequel les deux signaux réfléchis (153a, 153b) se propagent en retour vers le coupleur de sortie (167) fonctionnant dans la direction avant et fonctionnant comme un combineur de signaux adapté pour diviser les deux signaux réfléchis (153a, 153b) en deux composantes ayant la même amplitude et un déphasage relatif de 90° l'une par rapport à l'autre, de sorte que les composantes des deux signaux réfléchis (153a, 153b) au niveau du port isolé de sortie (164) connecté à l'entrée du signal de réception (141) soient chacune soumises à un déphasage relatif de 0° et à un déphasage relatif de 90°, de sorte qu'elles soient en phase et interfèrent de manière constructive l'une avec l'autre pour générer par leur addition le signal de réception (150) à l'entrée du signal de réception (141).

2. Procédé selon la revendication 1, dans lequel :
l'au moins un coupleur de sortie (167) est adapté pour combiner les signaux amplifiés (133a, 133b) de manière à ce que le signal d'émission (130) formé au port de sortie du signal d'émission (163) soit un signal d'entrée amplifié (131), et/ou
l'au moins un coupleur de sortie (167) est adapté pour combiner les signaux amplifiés (133a, 133b) de manière à ce qu'un signal (134) formé au niveau du port isolé de sortie d'émission (164) soit réduit dans son amplitude par rapport au signal d'émission (130).

3. Procédé selon la revendication 1 ou la revendication 2, dans lequel :
chaque coupleur d'entrée (165) est adapté pour diviser un signal en deux signaux de sortie de coupleur (132a, 132b) ayant une puissance réduite de 3 dB et une différence de phase de 90° l'un par rapport à l'autre.

4. Procédé selon l'une quelconque des revendications 1 à 3, dans lequel :
l'amplificateur de puissance équilibré en quadrature (160) comprend un coupleur d'entrée (165), deux amplificateurs de puissance (166a, 166b) et un coupleur de sortie (167).

5. Procédé selon l'une quelconque des revendications 1 à 3, dans lequel :
l'amplificateur de puissance équilibré en quadrature comprend plus d'un coupleur d'entrée (165), dans lequel :
une entrée d'un premier coupleur d'entrée est connectée au port d'entrée du signal d'émission, et
les autres coupleurs d'entrée sont disposés de telle sorte qu'une entrée de chacun des autres coupleurs d'entrée soit respectivement connectée à une sortie respective d'un autre des autres coupleurs d'entrée afin d'obtenir une structure arborescente des coupleurs d'entrée.

6. Procédé selon l'une quelconque des revendications 1 à 5, dans lequel :
des coupleurs hybrides sont utilisés pour les coupleurs d'entrée et/ou de sortie (165, 167), et/ou
les coupleurs d'entrée et/ou de sortie (165, 167) sont intégrés sur un substrat ou une puce semi-conductrice.

7. Procédé selon l'une quelconque des revendications 1 à 6, dans lequel les amplificateurs de puissance (166a, 166b) sont conçus pour avoir un coefficient de réflexion de sortie élevé.

8. Procédé selon l'une quelconque des revendications 1 à 7, dans lequel :
le chemin de réception (140) comprend un amplificateur d'entrée (142) adapté pour amplifier le signal de réception (150), et
une entrée de signal (143) de l'amplificateur d'entrée (142) est connectée au port isolé de sortie (164) de l'amplificateur de puissance équilibré en quadrature (160).

9. Procédé selon la revendication 8, dans lequel :
l'amplificateur d'entrée (142) est un amplificateur à faible bruit, et/ou
l'impédance d'entrée de l'amplificateur d'entrée (142) est adaptée à l'impédance caractéristique du module frontal radiofréquence (100).

10. Procédé selon l'une quelconque des revendications 1 à 9, dans lequel l'amplificateur de puissance équilibré en quadrature (160) comporte en outre un port d'entrée isolé (162).

11. Procédé selon la revendication 10, dans lequel un élément de terminaison (168) ayant une impédance correspondant à l'impédance caractéristique du module frontal radiofréquence (100) est connecté au port isolé d'entrée (162).

12. Procédé selon l'une quelconque des revendications 1 à 11, dans lequel une antenne (110) est connectée au port d'antenne (111).

13. Module frontal radiofréquence (100) pour la communication sans fil, le module frontal comprenant :
un port d'antenne (111) conçu pour connecter une antenne (110),
un chemin de réception (140) comprenant une entrée de signal de réception (141) adaptée pour générer un signal de réception (150) dans une opération de réception du module frontal radiofréquence (100), et
un chemin d'émission (120) adapté pour fournir un signal d'émission (130) au port d'antenne (111), le chemin d'émission (120) comprenant un amplificateur de puissance équilibré en quadrature (160) ayant un port de sortie de signal d'émission (163) connecté au port d'antenne (111) et un port de sortie isolé (164) connecté à l'entrée de signal de réception (141) ; et dans lequel l'amplificateur de puissance équilibré en quadrature (160) comprend en outre :
un port d'entrée de signal d'émission (161) adapté pour recevoir un signal d'entrée (131) dans une opération d'émission du module frontal radiofréquence (100),
un coupleur d'entrée (165) conçu pour diviser le signal d'entrée (131) en deux signaux de sortie de coupleur (132a, 132b) dans l'opération d'émission,
deux amplificateurs de puissance (166a, 166b), chaque amplificateur de puissance (166a, 166b) étant adapté pour amplifier l'un des deux signaux de sortie de coupleur (132a, 132b) afin d'obtenir un signal amplifié respectif (133a, 133b),
un coupleur de sortie (167) connecté au port de sortie du signal d'émission (163) et au port isolé de sortie (164) de l'amplificateur de puissance équilibré en quadrature (160), dans lequel le coupleur d'entrée (165) et le coupleur de sortie (167) sont adaptés pour diviser le signal d'émission (131) et combiner les signaux amplifiés (133a, 133b), respectivement, de sorte que les composants des deux signaux amplifiés (133a, 133b) aient été soumis à un déphasage de 0° et à un déphasage de 90° et que les signaux amplifiés (133a, 133b) soient en phase et interfèrent de manière constructive l'un avec l'autre au niveau du port de sortie du signal d'émission (163),
et le coupleur d'entrée (165) et le coupleur de sortie (167) sont adaptés pour diviser le signal d'émission (131) et combiner les signaux amplifiés (133a, 133b), respectivement, de sorte qu'une composante d'un premier signal amplifié (133a) d'un amplificateur de puissance (166a) ait été soumise deux fois à un déphasage relatif de 0° et qu'une composante d'un deuxième signal amplifié (133b) de l'autre amplificateur de puissance (166b) ait été soumise deux fois à un déphasage relatif de 90° et que les signaux amplifiés (133a, 133b) aient une différence de phase de 180° et interfèrent de manière destructive l'un avec l'autre au niveau du port isolé de sortie (164) ; et
dans lequel, dans l'opération de réception du module frontal radiofréquence (100), lorsqu'un signal (151) est reçu de l'antenne (110), le signal (151) est fourni au port de sortie de signal d'émission (163) de l'amplificateur de puissance équilibré en quadrature (160) et donc au coupleur de sortie (167) adapté pour fonctionner comme un diviseur de signal afin de diviser le signal (151) reçu de l'antenne (110) en deux signaux entrants (152a, 152b) ayant la même amplitude et une différence de phase de 90° chacun fourni à une sortie d'un amplificateur de puissance correspondant (166a, 166b) où les signaux entrants 152a, 152b sont réfléchis vers les sorties des amplificateurs de puissance (166a, 166b) pour obtenir deux signaux réfléchis (153a, 153b) ayant la même amplitude et une différence de phase relative de 90°, dans lequel les deux signaux réfléchis (153a, 153b) se propagent en retour vers le coupleur de sortie (167) fonctionnant dans la direction avant et fonctionnant comme un combineur de signaux adapté pour diviser les deux signaux réfléchis (153a, 153b) en deux composantes ayant la même amplitude et un déphasage relatif de 90° l'une par rapport à l'autre, de sorte que les composantes des deux signaux réfléchis (153a, 153b) au niveau du port isolé de sortie (164) connecté à l'entrée du signal de réception (141) soient chacune soumises à un déphasage relatif de 0° et à un déphasage relatif de 90°, de sorte qu'elles soient en phase et interfèrent de manière constructive l'une avec l'autre pour générer par leur addition le signal de réception (150) à l'entrée du signal de réception (141).

14. Module frontal radiofréquence (100) selon la revendication 13, dans lequel :
l'au moins un coupleur de sortie (167) est adapté pour combiner les signaux amplifiés (133a, 133b) de manière à ce que le signal d'émission (130) formé au niveau du port de sortie du signal d'émission (163) soit un signal d'entrée amplifié (131), et/ou
l'au moins un coupleur de sortie (167) est adapté pour combiner les signaux amplifiés (133a, 133b) de manière à ce qu'un signal (134) formé au niveau du port isolé de sortie d'émission (164) soit réduit dans son amplitude par rapport au signal d'émission (130).

15. Module frontal radiofréquence (100) selon la revendication 13 ou la revendication 14, dans lequel :
chaque coupleur d'entrée (165) est adapté pour diviser un signal en deux signaux de sortie de coupleur (132a, 132b) ayant une puissance réduite de 3 dB et une différence de phase de 90° l'un par rapport à l'autre.
